# EUROPEAN PATENT APPLICATION

(11) **EP 4 349 639 A1**
(43) Date of publication of application: **10.04.2024**
(21) Application number: 21947616.5
(22) Date of filing: 30.06.2021
(51) Int. Cl.: B60L 53/31, B60L 53/302, H02J 7/00, H05K 7/20

(54) **CHARGING GUN, CHARGING SEAT, CHARGING DEVICE, DEVICE TO BE CHARGED, CHARGING SYSTEM, AND CONTROL METHOD**

(71) Applicant: Huawei Technologies Co., Ltd., Shenzhen, Guangdong 518129 (CN)
(72) Inventor: WANG, Deyuan, Shenzhen, Guangdong 518129 (CN); FENG, Hui, Shenzhen, Guangdong 518129 (CN); PAN, Liwen, Shenzhen, Guangdong 518129 (CN)
(74) Representative: Pfenning, Meinig & Partner mbB
(86) International application number: PCT/CN2021/103877
(87) International publication number: WO 2023/272663

(57) **Abstract**

This application provides a charging plug and socket-outlet, charging and to-be-charged apparatuses, a charging system, and a control method. The charging system includes: a charging apparatus and a to-be-charged apparatus. The charging apparatus includes a charging plug and a first cooling system. The charging plug includes a first electrical transmission interface, a first heat conduction output interface, and a first heat conduction input interface. The to-be-charged apparatus includes a battery, a charging socket-outlet, and a second cooling system. The charging socket-outlet includes a second electrical transmission interface, a second heat conduction output interface, and a second heat conduction input interface. When the first electrical transmission interface, the first heat conduction output interface, and the first heat conduction input interface in the charging plug are respectively connected to the second electrical transmission interface, the second heat conduction input interface, and the second heat conduction output interface in the charging socket-outlet, the first cooling system in the charging apparatus and the second cooling system in the to-be-charged apparatus form a heat conduction loop. The solutions of this application can be used to meet a heat dissipation requirement of the battery in the to-be-charged apparatus during super charging.

## Description

### TECHNICAL FIELD

This application relates to the field of heat dissipation technologies, and more specifically, to a charging plug and socket-outlet, charging and to-be-charged apparatuses, a charging system, and a control method.

### BACKGROUND

To resolve user pains of long charging time, a super charging (namely, high-power and high-current charging) technology is greatly developed. However, in a high-power and high-current charging process, a battery in a to-be-charged apparatus (for example, electric vehicle) has an extremely high heat dissipation requirement.

In the conventional charging system, a charging apparatus and a to-be-charged apparatus each have a cooling system, and dissipate heat for components with heat dissipation requirements. However, power of the cooling system in the to-be-charged apparatus is low. Consequently, it is difficult to meet the extremely high heat dissipation requirement of the battery during super charging.

### SUMMARY

This application provides a charging plug and socket-outlet, a charging and to-be-charged apparatus, a charging system, and a control method, to meet a heat dissipation requirement of a battery in a to-be-charged apparatus during super charging.

According to a first aspect, a charging plug is provided. The charging plug includes a first electrical transmission interface, a first heat conduction output interface, and a first heat conduction input interface. The first electrical transmission interface is configured to transmit electric energy to a to-be-charged apparatus, the first heat conduction output interface is configured to output a heat conduction medium to the to-be-charged apparatus, and the first heat conduction input interface is configured to receive the heat conduction medium input from the to-be-charged apparatus.

The charging plug provided in an embodiment of this application includes the first electrical transmission interface, the first heat conduction output interface, and the first heat conduction input interface. The first electrical transmission interface is configured to transmit the electric energy to the to-be-charged apparatus, the first heat conduction output interface is configured to output the heat conduction medium to the to-be-charged apparatus, and the first heat conduction input interface is configured to receive the heat conduction medium input from the to-be-charged apparatus, to implement electrical transmission and heat conduction media transmission between the charging plug and the to-be-charged apparatus.

With reference to the first aspect, in some implementations of the first aspect, the first heat conduction output interface and/or the first heat conduction input interface use/uses a quick plug in/out anti-overflow interconnection connector.

With reference to the first aspect, in some implementations of the first aspect, the charging plug further includes a first communication interface, and the first communication interface is configured to communicate with the to-be-charged apparatus.

According to a second aspect, a charging socket-outlet is provided. The charging socket-outlet includes a second electrical transmission interface, a second heat conduction output interface, and a second heat conduction input interface. The second electrical transmission interface is configured to transmit electric energy to a charging apparatus, the second heat conduction output interface is configured to output a heat conduction medium to the charging apparatus, and the second heat conduction input interface is configured to receive the heat conduction medium input from the charging apparatus.

The charging socket-outlet provided in an embodiment of this application includes the second electrical transmission interface, the second heat conduction output interface, and the second heat conduction input interface. The second electrical transmission interface is configured to transmit the electric energy to the charging apparatus, the second heat conduction output interface is configured to output the heat conduction medium to the charging apparatus, and the second heat conduction input interface is configured to receive the heat conduction medium input from the charging apparatus, to implement electrical transmission and heat conduction media transmission between the charging socket-outlet and the charging apparatus.

With reference to the second aspect, in some implementations of the second aspect, the second heat conduction output interface and/or the second heat conduction input interface use/uses a quick plug in/out anti-overflow interconnection connector.

With reference to the second aspect, in some implementations of the second aspect, the charging socket-outlet further includes a second communication interface, and the second communication interface is configured to communicate with the charging apparatus.

According to a third aspect, a charging apparatus is provided. The charging apparatus includes the charging plug according to any one of the first aspect or the possible implementations of the first aspect and a first cooling system. The first cooling system includes a first cooling apparatus, a first heat conduction pipeline, and a second heat conduction pipeline. The first cooling apparatus is configured to cool the first heat conduction pipeline and the second heat conduction pipeline. One end of the first heat conduction pipeline communicates with one end of the second heat conduction pipeline. The other end of the first heat conduction pipeline and the other end of the second heat conduction pipeline are respectively connected to a first heat conduction output interface and a first heat conduction input interface in the charging plug.

The first cooling system in the charging apparatus provided in an embodiment of this application can be connected to the first heat conduction output interface and the first heat conduction input interface in the charging plug. The first heat conduction output interface is configured to output a heat conduction medium to a to-be-charged apparatus, and the first heat conduction input interface is configured to receive the heat conduction medium input from the to-be-charged apparatus. In this way, the charging apparatus and the to-be-charged apparatus can exchange heat conduction media, and then the first cooling system in the charging apparatus can cool the to-be-charged apparatus.

With reference to the third aspect, in some implementations of the third aspect, the first cooling apparatus may include any one of an air conditioner compressor cooling system, a fan heat sink cooling system, a phase change material cooling system, and the like.

With reference to the third aspect, in some implementations of the third aspect, the first cooling system may further include a first heating apparatus, where the first heating apparatus is configured to heat the first heat conduction pipeline and the second heat conduction pipeline.

The first cooling system in the charging apparatus in this embodiment of this application may further include the first heating apparatus, so that the first cooling system in the charging apparatus can heat the to-be-charged apparatus.

With reference to the third aspect, in some implementations of the third aspect, the first heating apparatus may include any one of a positive temperature coefficient PTC thermistor heating system, a heat pump system, a motor preheating system, and the like.

According to a fourth aspect, a to-be-charged apparatus is provided. The to-be-charged apparatus includes a battery, the charging socket-outlet according to any one of the second aspect or the possible implementations of the second aspect, and a second cooling system. The second cooling system includes a third heat conduction pipeline and a fourth heat conduction pipeline. One end of the third heat conduction pipeline and one end of the fourth heat conduction pipeline are connected to the battery and communicate with each other. The other end of the third heat conduction pipeline and the other end of the fourth heat conduction pipeline are respectively connected to a second heat conduction input interface and a second heat conduction output interface in the charging socket-outlet.

The second cooling system in the to-be-charged apparatus provided in an embodiment of this application can be connected to the second heat conduction output interface and the second heat conduction input interface in the charging socket-outlet. The second heat conduction output interface is configured to output a heat conduction medium to a charging apparatus, and the second heat conduction input interface is configured to receive the heat conduction medium input from the charging apparatus. In this way, the charging apparatus and the to-be-charged apparatus can exchange heat conduction media.

With reference to the fourth aspect, in some implementations of the fourth aspect, the second cooling system may further include a second cooling apparatus, where the second cooling apparatus is configured to cool the third heat conduction pipeline and the fourth heat conduction pipeline.

With reference to the fourth aspect, in some implementations of the fourth aspect, the second cooling apparatus may include any one of an air conditioner compressor cooling system, a fan heat sink cooling system, a phase change material cooling system, and the like.

With reference to the fourth aspect, in some implementations of the fourth aspect, the second cooling system may further include a second heating apparatus, where the second heating apparatus is configured to heat the third heat conduction pipeline and the fourth heat conduction pipeline.

With reference to the fourth aspect, in some implementations of the fourth aspect, the second heating apparatus may include any one of a positive temperature coefficient PTC thermistor heating system, a heat pump system, a motor preheating system, and the like.

According to a fifth aspect, a charging system is provided. The charging system includes the charging apparatus according to any one of the third aspect or the possible implementations of the third aspect and the to-be-charged apparatus according to any one of the fourth aspect or the possible implementations of the fourth aspect. When a first electrical transmission interface, a first heat conduction output interface, and a first heat conduction input interface in a charging plug in the charging apparatus are respectively connected to a second electrical transmission interface, a second heat conduction input interface, and a second heat conduction output interface in a charging socket-outlet in the to-be-charged apparatus, a first cooling system in the charging apparatus and a second cooling system in the to-be-charged apparatus form a heat conduction loop.

According to the charging system provided in an embodiment of this application, two heat conduction interfaces are added to each of a conventional charging plug and a conventional charging socket-outlet, and are connected to respective cooling systems. In this way, during charging, the cooling systems in the charging apparatus and the to-be-charged apparatus may be integrally connected through interface connections, to implement exchange between heat conduction media, so that a heat dissipation requirement of a battery in the to-be-charged apparatus can be met by using the high-power cooling system in the charging apparatus.

According to a sixth aspect, a charging pile is provided. The charging pile includes the charging plug according to any one of the first aspect or the possible implementations of the first aspect; and/or includes the charging apparatus according to any one of the third aspect or the possible implementations of the third aspect.

According to a seventh aspect, a mobile charging vehicle is provided. The mobile charging vehicle includes the charging plug according to any one of the first aspect or the possible implementations of the first aspect; and/or includes the charging apparatus according to any one of the third aspect or the possible implementations of the third aspect.

According to an eighth aspect, an electric vehicle is provided. The electric vehicle includes the charging plug according to any one of the first aspect or the possible implementations of the first aspect; or includes the charging apparatus according to any one of the third aspect or the possible implementations of the third aspect; or includes the charging socket-outlet according to any one of the second aspect or the possible implementations of the second aspect; or includes the to-be-charged apparatus according to any one of the fourth aspect or the possible implementations of the fourth aspect.

According to a ninth aspect, a control method is provided. The method is applied to the charging system according to any one of the fifth aspect or the possible implementations of the fifth aspect, and a first cooling system in a charging apparatus in the charging system and a second cooling system in a to-be-charged apparatus in the charging system form a heat conduction loop. The method includes: determining, in a charging process, whether a first temperature of a battery in the to-be-charged apparatus meets a first preset condition; and if the first temperature does not meet the first preset condition, turning on a first cooling apparatus in the first cooling system to cool the battery.

It should be understood that, in the charging process, a temperature of the battery usually rises, and especially in a super charging process, a temperature of the battery rises sharply. In this case, in the charging process, whether the battery needs to be cooled needs to be determined based on the temperature of the battery.

It should be understood that determining whether the first temperature meets the first preset condition may be determining whether the first temperature in the charging process is less than a first preset value. If the first temperature is less than the first preset value, the first temperature meets the first preset condition; or if the first temperature is greater than or equal to the first preset value, the first temperature does not meet the first preset condition.

In an embodiment of this application, if the first temperature of the battery does not meet the first preset condition, in other words, when the first temperature is high, the battery may be cooled by using a cooling function of the first cooling system in the charging apparatus. This can improve a heat dissipation effect of the battery, and reduce power consumption of the to-be-charged apparatus.

Correspondingly, if the first temperature meets the first preset condition, the first cooling apparatus in the first cooling system may not be turned on.

Optionally, after the first cooling apparatus in the first cooling system is turned on to cool the battery, if the system determines that a battery level of the battery meets the first preset condition, the system may choose to keep the first cooling apparatus in the first cooling system on or turn off the first cooling apparatus in the first cooling system. This is not limited. Optionally, in an actual charging process, the first cooling apparatus in the first cooling system may be directly turned on without determining the temperature of the battery, to control the temperature of the battery to fall within an appropriate range in the charging process. This is not limited in this application.

With reference to the ninth aspect, in some implementations of the ninth aspect, the first preset condition includes: The first temperature is less than the first preset value.

With reference to the ninth aspect, in some implementations of the ninth aspect, the method further includes: determining, before charging, whether a second temperature of the battery in the to-be-charged apparatus meets a second preset condition; and if the second temperature does not meet the second preset condition, turning on the first cooling apparatus or a first heating apparatus in the first cooling system to cool or heat the battery. The second preset condition includes: The second temperature falls within a preset temperature range, or the second temperature is a second preset value.

It should be understood that determining whether the second temperature meets the second preset condition may be determining whether the second temperature before charging falls within the preset temperature range or is the second preset value. If the second temperature falls within the preset temperature range, the second temperature meets the second preset condition; or if the second temperature does not fall within the preset temperature range, the second temperature does not meet the second preset condition; or if the second temperature is the second preset value, the second temperature meets the second preset condition; or if the second temperature is not the second preset value, the second temperature does not meet the second preset condition.

It should be understood that, before charging, especially before super charging, a charging condition can be met only when the temperature of the battery falls within the appropriate temperature range or is the second preset value. Therefore, in this embodiment of this application, before charging is performed, if the second temperature of the battery does not meet the second preset condition, the battery may be cooled or heated by using a cooling function or a heating function of the first cooling system in the charging apparatus, so that the temperature of the battery can meet the charging condition.

With reference to the ninth aspect, in some implementations of the ninth aspect, the method further includes: determining, after charging, whether a third temperature of the battery in the to-be-charged apparatus meets a third preset condition; and if the third temperature does not meet the third preset condition, turning on the first cooling apparatus to cool the battery. The third preset condition includes: The third temperature is less than a third preset value.

It should be understood that determining whether the third temperature meets the third preset condition may be determining whether the third temperature after charging is less than the third preset value. If the third temperature is less than the third preset value, the third temperature meets the third preset condition; or if the third temperature is greater than or equal to the third preset value, the third temperature does not meet the third preset condition.

In this embodiment of this application, after charging is performed, if the third temperature of the battery does not meet the third preset condition, the battery may be cooled by using the cooling function of the first cooling system in the charging apparatus, to facilitate normal use of the battery subsequently.

According to a tenth aspect, a control apparatus is provided. The apparatus is used in the charging system according to any one of the fifth aspect or the possible implementations of the fifth aspect, and a first cooling system in a charging apparatus in the charging system and a second cooling system in a to-be-charged apparatus in the charging system form a heat conduction loop. The apparatus includes a processing unit. In a charging process, the processing unit is configured to: determine whether a first temperature of a battery in the to-be-charged apparatus meets a first preset condition; and if the first temperature does not meet the first preset condition, turn on a first cooling apparatus in the first cooling system to cool the battery.

With reference to the tenth aspect, in some implementations of the tenth aspect, the first preset condition includes: The first temperature is less than a first preset value.

With reference to the tenth aspect, in some implementations of the tenth aspect, before charging, the processing unit is further configured to: determine whether a second temperature of the battery in the to-be-charged apparatus meets a second preset condition; and if the second temperature does not meet the second preset condition, turn on the first cooling apparatus or a first heating apparatus in the first cooling system to cool or heat the battery. The second preset condition includes: The second temperature falls within a preset temperature range, or the second temperature is a second preset value.

With reference to the tenth aspect, in some implementations of the tenth aspect, after charging, the processing unit is further configured to: determine whether a third temperature of the battery in the to-be-charged apparatus meets a third preset condition; and if the third temperature does not meet the third preset condition, turn on the first cooling apparatus to cool the battery. The third preset condition includes: The third temperature is less than a third preset value.

According to an eleventh aspect, a control apparatus is provided, and includes a processor and a memory. The processor runs instructions in the memory, so that the control apparatus performs the control method according to any one of the ninth aspect or the possible implementations of the ninth aspect.

According to a twelfth aspect, a computer-readable storage medium is provided, and includes instructions. The instructions are used to implement the control method according to any one of the ninth aspect or the possible implementations of the ninth aspect.

According to a thirteenth aspect, a computing device is provided, and includes at least one processor and a memory. The at least one processor is coupled to the memory, and is configured to read and execute instructions in the memory, to perform the control method according to any one of the ninth aspect or the possible implementations of the ninth aspect.

According to a fourteenth aspect, a computer program product including instructions is provided. When the computer program product runs on a computer, the computer is enabled to perform the control method according to any one of the ninth aspect or the possible implementations of the ninth aspect.

According to a fifteenth aspect, a chip is provided. The chip includes a processor and a data interface. The processor reads, through the data interface, instructions stored in a memory, to perform the control method according to any one of the ninth aspect or the possible implementations of the ninth aspect.

Optionally, in an implementation, the chip may further include the memory. The memory stores the instructions, and the processor is configured to execute the instructions stored in the memory. When the instructions are executed, the processor is configured to perform the control method according to any one of the ninth aspect or the possible implementations of the ninth aspect.

According to a sixteenth aspect, a chip system is provided. The chip system includes at least one processor, configured to support implementation of functions according to the ninth aspect or some implementations of the ninth aspect.

In a possible design, the chip system further includes a memory. The memory is configured to store program instructions and data, and the memory is located inside or outside the processor. The chip system may include a chip, or may include a chip and another discrete component.

### BRIEF DESCRIPTION OF DRAWINGS

FIG. 1 is an example diagram of a conventional charging system;
FIG. 2 is an example diagram of a charging system according to an embodiment of this application;
FIG. 3 is an example diagram of a charging system including a charging pile and a to-be-charged vehicle according to an embodiment of this application;
FIG. 4 is an example diagram of a charging system including a mobile charging vehicle and a to-be-charged vehicle according to an embodiment of this application;
FIG. 5 is an example diagram of a control method according to an embodiment of this application;
FIG. 6 is an example diagram of an operation procedure during charging according to an embodiment of this application;
FIG. 7 is an example diagram of a control apparatus according to an embodiment of this application; and
FIG. 8 is a block diagram of an example of a hardware structure of a control apparatus according to an embodiment of this application.

### DESCRIPTION OF EMBODIMENTS

The following describes technical solutions of this application with reference to accompanying drawings.

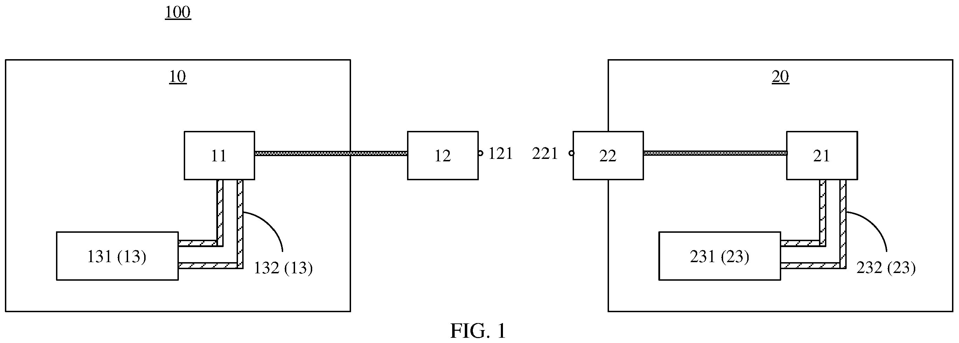

FIG. 1 is an example diagram of a conventional charging system. As shown in FIG. 1, the conventional charging system 100 includes a charging apparatus 10 and a to-be-charged apparatus 20.

The charging apparatus 10 mainly includes a power supply 11, a charging plug 12, and a charging apparatus cooling system 13. The charging apparatus cooling system 13 includes a first cooling apparatus 131 and a first heat conduction loop 132. The first heat conduction loop 132 is connected to the power supply 11, and is configured to dissipate heat for the power supply 11 during charging. The charging plug 12 includes a first electrical transmission interface 121, configured to transmit electric energy to the to-be-charged apparatus 20.

The to-be-charged apparatus 20 mainly includes a battery 21, a charging socket-outlet 22, and a to-be-charged apparatus cooling system 23. The to-be-charged apparatus cooling system 23 includes a second cooling apparatus 231 and a second heat conduction loop 232. The second heat conduction loop 232 is connected to the battery 21, and is configured to dissipate heat for the battery 21 during charging. The charging socket-outlet 22 includes a second electrical transmission interface 221, configured to transmit electric energy to the charging apparatus 10.

It can be learned that, in the conventional charging system, the charging apparatus and the to-be-charged apparatus each have a cooling system, and dissipate heat for a component that has a heat dissipation requirement. However, for the to-be-charged apparatus during super charging, the battery in the to-be-charged apparatus has an extremely high heat dissipation requirement, but power of the cooling system in the to-be-charged apparatus is low. Consequently, it is difficult to meet the extremely high heat dissipation requirement of the battery.

Based on this, this application provides a charging system. Two heat conduction interfaces are added to each of the conventional charging plug and the conventional charging socket-outlet, and are connected to respective cooling systems. In this way, during charging, the cooling systems in the charging apparatus and the to-be-charged apparatus may be integrally connected through interface connections, to implement exchange between heat conduction media, so that a heat dissipation requirement of a to-be-charged vehicle can be met by using the high-power cooling system in the charging apparatus.

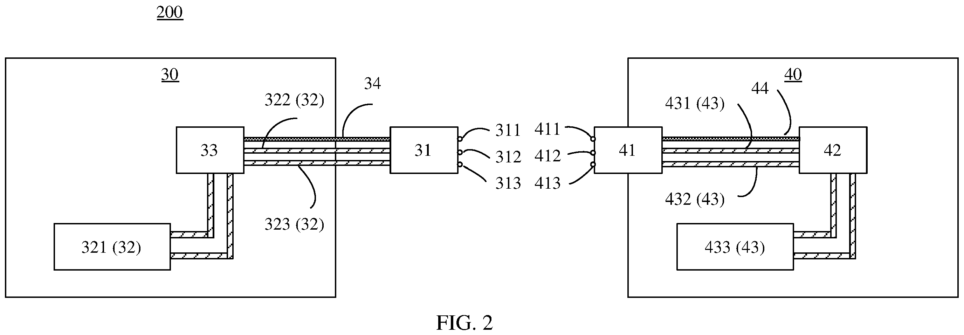

FIG. 2 is an example diagram of a charging system according to an embodiment of this application. As shown in FIG. 2, the charging system 200 includes a charging apparatus 30 and a to-be-charged apparatus 40. The charging apparatus 30 may be a charging pile, or may be a mobile charging apparatus (for example, a mobile charging vehicle). The to-be-charged apparatus 40 may be a to-be-charged vehicle. Specific types of the charging apparatus 30 and the to-be-charged apparatus 40 are not limited in this application.

The charging apparatus 30 is first described.

The charging apparatus 30 includes a charging plug 31 and a first cooling system 32. The first cooling system 32 includes a first cooling apparatus 321, a first heat conduction pipeline 322, and a second heat conduction pipeline 323. The charging apparatus 30 further includes a power supply 33 and a first cable 34. The power supply 33 is configured to provide electric energy for the to-be-charged apparatus 40, and the first cable 34 is configured to transmit the electric energy.

The charging plug 31 includes a first electrical transmission interface 311, a first heat conduction output interface 312, and a first heat conduction input interface 313. The first electrical transmission interface 311 is configured to transmit the electric energy to the to-be-charged apparatus 40, the first heat conduction output interface 312 is configured to output a heat conduction medium to the to-be-charged apparatus 40, and the first heat conduction input interface 313 is configured to receive the heat conduction medium input from the to-be-charged apparatus 40.

Optionally, the charging plug 31 may further include a first communication interface (not shown), and the first communication interface is configured to communicate with the to-be-charged apparatus 40.

Optionally, the first communication interface and the first electrical transmission interface 311 in the charging plug 31 each may be a GB standard interface. It should be understood that, in practice, the first communication interface and the first electrical transmission interface 311 may alternatively not be limited thereto. However, for ease of description, the GB standard interface is used as an example in the following embodiments.

Optionally, the first heat conduction output interface 312 and/or the first heat conduction input interface 313 may use a quick plug in/out anti-overflow interconnection connector, or may use an interconnection connector of another type. This is not limited in this application.

It should be understood that the quick plug in/out anti-overflow interconnection connector has the following advantages: an equipped high-precision built-in flush valve, elastic sealing, manual plug in/out or automatic plug in/out, and use in a connection of heat conduction pipelines. Therefore, preferably, an example in which the first heat conduction output interface 312 and the first heat conduction input interface 313 each use the quick plug in/out anti-overflow interconnection connector is used for description in the following embodiments.

Optionally, the first heat conduction output interface 312 and the first heat conduction input interface 313 may be independent of the first electrical transmission interface 311, and may be separately connected to a charging socket-outlet 41 in the to-be-charged apparatus 40, or may be integrated into the GB standard interface. This is not limited in this application.

Optionally, the first heat conduction output interface 312 and the first heat conduction input interface 313 may be disposed on a same interface of the charging plug 31 as the first electrical transmission interface 311, to save space. Alternatively, the first heat conduction output interface 312 and the first heat conduction input interface 313 may not be disposed on a same interface of the charging plug 31 as the first electrical transmission interface 311. For example, heat conduction pipelines of the first heat conduction output interface 312 and the first heat conduction input interface 313 may extend from the charging plug 31. This is not limited in this application.

It should be understood that, in the charging apparatus 30, the first cooling apparatus 321 is mainly configured to cool the first heat conduction pipeline 322 and the second heat conduction pipeline 323. One end of the first heat conduction pipeline 322 communicates with one end of the second heat conduction pipeline 323, and the other end of the first heat conduction pipeline 322 and the other end of the second heat conduction pipeline 323 are respectively connected to the first heat conduction output interface 312 and the first heat conduction input interface 313 in the charging plug 31.

It should be understood that communication between the one end of the first heat conduction pipeline 322 and the one end of the second heat conduction pipeline 323 mainly means that when the charging apparatus 30 and the to-be-charged apparatus 40 are not interconnected, the one end of the first heat conduction pipeline 322 communicates with the one end of the second heat conduction pipeline 323 in the charging apparatus 30. The communication may be specifically direct communication or indirect communication. This is not limited in this application. For example, the one end of the first heat conduction pipeline 322 may communicate with the one end of the second heat conduction pipeline 323 through a heat conduction channel inside the power supply 33, to simultaneously cool the power supply 33. Alternatively, the one end of the first heat conduction pipeline 322 may communicate with the one end of the second heat conduction pipeline 323 through a heat conduction channel inside the power supply 33 and a heat conduction pipeline outside the power supply 33. Alternatively, the one end of the first heat conduction pipeline 322 may communicate with the one end of the second heat conduction pipeline 323 through another heat conduction pipeline. Alternatively, the one end of the first heat conduction pipeline 322 may directly communicate with the one end of the second heat conduction pipeline 323 without passing through the power supply 33. In this case, a conventional cooling manner of separately setting a heat conduction loop may be applied to the charging apparatus 30, to cool the power supply 33. This is not limited in this application.

It should be understood that the other end of the first heat conduction pipeline 322 and the other end of the second heat conduction pipeline 323 are respectively connected to the first heat conduction output interface 312 and the first heat conduction input interface 313 in the charging plug 31. This means that when the charging apparatus 30 and the to-be-charged apparatus 40 are not interconnected, the other end of the first heat conduction pipeline 322 does not communicate with the other end of the second heat conduction pipeline 323. After the charging apparatus 30 and the to-be-charged apparatus 40 are interconnected, the other end of the first heat conduction pipeline 322 may communicate with the other end of the second heat conduction pipeline 323 through the interfaces and the cooling system in the to-be-charged apparatus 40.

Optionally, the first cooling apparatus 321 may be any one of an air conditioner compressor cooling system, a fan heat sink cooling system, a phase change material cooling system, and the like. This is not limited in this application.

It should be understood that super charging is performed only when a temperature of a battery 42 in the to-be-charged apparatus 40 falls within an appropriate temperature range. In this case, if the temperature of the battery 42 is low or high during super charging, the battery 42 needs to be preheated or cooled to the appropriate temperature range.

Therefore, optionally, the first cooling system 32 may further include a first heating apparatus (not shown), and the first heating apparatus is configured to heat the first heat conduction pipeline 322 and the second heat conduction pipeline 323. In this way, when super charging is performed after the charging apparatus 30 and the to-be-charged apparatus 40 are interconnected, if the temperature of the battery 42 is low, the battery 42 may be heated by using a heating function of the cooling system in the charging apparatus 30.

Optionally, the first heating apparatus may be any one of a positive temperature coefficient PTC thermistor heating system, a heat pump system, a motor preheating system, and the like. This is not limited in this application.

Optionally, a cooling pipeline may be further integrated inside the first cable 34, or a cooling pipeline may be wrapped outside the first cable 34, to cool the first cable 34 during charging. A cooling manner of the first cable 34 is not limited in this application.

Optionally, the charging apparatus 30 may further include a first control system, configured to control communication interaction with a second control system and the battery 42 in the to-be-charged apparatus 40, including a GB standard charging handshake procedure and determining of a charging power capability and a battery temperature status.

Then, the to-be-charged apparatus 40 is described.

The to-be-charged apparatus 40 includes a charging socket-outlet 41, the battery 42, and a second cooling system 43. The second cooling system 43 includes a third heat conduction pipeline 431 and a fourth heat conduction pipeline 432. The to-be-charged apparatus 40 further includes a second cable 44. The second cable 44 is configured to transmit electric energy.

The charging socket-outlet 41 includes a second electrical transmission interface 411, a second heat conduction output interface 413, and a second heat conduction input interface 412. The second electrical transmission interface 411 is configured to transmit electric energy to the charging apparatus 30, the second heat conduction output interface 413 is configured to output a heat conduction medium to the charging apparatus 30, and the second heat conduction input interface 312 is configured to receive the heat conduction medium input from the charging apparatus 30.

Optionally, the charging socket-outlet 41 may further include a second communication interface (not shown), and the second communication interface is configured to communicate with the charging apparatus 30.

Optionally, the second communication interface and the second electrical transmission interface 411 in the charging socket-outlet 41 each may be a GB standard interface. It should be understood that, in practice, the second communication interface and the second electrical transmission interface 411 may alternatively not be limited thereto. However, for ease of description, the GB standard interface is used as an example in the following embodiments.

Optionally, the second heat conduction output interface 413 and/or the second heat conduction input interface 412 may use a quick plug in/out anti-overflow interconnection connector, or may use an interconnection connector of another type. This is not limited in this application.

It should be understood that the quick plug in/out anti-overflow interconnection connector has the following advantages: an equipped high-precision built-in flush valve, elastic sealing, manual plug in/out or automatic plug in/out, and use in a connection of heat conduction pipelines. Therefore, preferably, an example in which the second heat conduction output interface 413 and the second heat conduction input interface 412 each use the quick plug in/out anti-overflow interconnection connector is used for description in the following embodiments.

Further, it should be noted that interfaces for interconnection between the charging plug 31 and the charging socket-outlet 41 shall be of a same type, so that the charging plug 31 and the charging socket-outlet 41 can be interconnected and implement corresponding functions. To be specific, the first communication interface and the second communication interface shall be of the same type; the first electrical transmission interface 311 and the second electrical transmission interface 411 shall be of the same type; the first heat conduction output interface 312 and the second heat conduction input interface 412 shall be of the same type; and the first heat conduction input interface 313 and the second heat conduction output interface 413 shall be of the same type.

Optionally, the second heat conduction output interface 413 and the second heat conduction input interface 412 may be independent of the second electrical transmission interface 411, and may be separately connected to the charging plug 31 in the charging apparatus 30, or may be integrated into the GB standard interface. This is not limited in this application.

Optionally, the second heat conduction output interface 413 and the second heat conduction input interface 412 may be disposed on a same interface of the charging socket-outlet 41 as the second electrical transmission interface 411, to save space. Alternatively, the second heat conduction output interface 413 and the second heat conduction input interface 412 may not be disposed on a same interface of the charging socket-outlet 41 as the second electrical transmission interface 411. For example, heat conduction pipelines of the second heat conduction output interface 413 and the second heat conduction input interface 412 may extend from the charging socket-outlet 41. This is not limited in this application.

It should be understood that, in the to-be-charged apparatus 40, one end of the third heat conduction pipeline 431 and one end of the fourth heat conduction pipeline 432 are connected to the battery 42 and communicate with each other, and the other end of the third heat conduction pipeline 431 and the other end of the fourth heat conduction pipeline 432 are respectively connected to the second heat conduction input interface 412 and the second heat conduction output interface 413 in the charging socket-outlet 41.

It should be understood that connecting to the battery 42 and communicating with each other by the one end of the third heat conduction pipeline 431 and the one end of the fourth heat conduction pipeline 432 mainly means that when the charging apparatus 30 and the to-be-charged apparatus 40 are not interconnected, the one end of the third heat conduction pipeline 431 and the one end of the fourth heat conduction pipeline 432 are connected to the battery 42 in the to-be-charged apparatus 30 and communicate with each other. For example, the one end of the third heat conduction pipeline 431 may communicate with the one end of the fourth heat conduction pipeline 432 through a heat conduction channel inside the battery 42. Alternatively, the one end of the third heat conduction pipeline 431 may communicate with the one end of the fourth heat conduction pipeline 432 through a heat conduction channel inside the battery 42 and a heat conduction pipeline outside the battery 42. This is not limited in this application.

It should be understood that the other end of the third heat conduction pipeline 431 and the other end of the fourth heat conduction pipeline 432 are respectively connected to the second heat conduction input interface 412 and the second heat conduction output interface 413 in the charging socket-outlet 41. This means that when the charging apparatus 30 and the to-be-charged apparatus 40 are not interconnected, the other end of the third heat conduction pipeline 431 does not communicate with the other end of the fourth heat conduction pipeline 432. After the charging apparatus 30 and the to-be-charged apparatus 40 are interconnected, the other end of the third heat conduction pipeline 431 may communicate with the other end of the fourth heat conduction pipeline 432 through the interfaces and the cooling system in the charging apparatus 30.

Optionally, the second cooling system 43 may further include a second cooling apparatus 433, to cool the third heat conduction pipeline 431 and the fourth heat conduction pipeline 432. In this case, in the charging process, the first cooling apparatus 321 in the charging apparatus 30 and the second cooling apparatus 433 in the to-be-charged apparatus 40 may be simultaneously turned on. Alternatively, only the first cooling apparatus 321 in the charging apparatus 30 may be turned on, so that the battery 42 requiring heat dissipation in the to-be-charged apparatus 40 is cooled by the high-power first cooling apparatus 321 in the charging apparatus 30, to ensure that a temperature of the battery 42 falls within an appropriate range.

Optionally, the second cooling system 43 may not include a second cooling apparatus 433, to reduce a size and a weight of the to-be-charged apparatus 40. In this case, in the charging process, the first cooling apparatus 321 in the charging apparatus 30 may be turned on, so that the battery 42 requiring heat dissipation in the to-be-charged apparatus 40 is cooled by the high-power first cooling apparatus 321 in the charging apparatus 30, to ensure that a temperature of the battery 42 falls within an appropriate range.

Optionally, the second cooling apparatus 433 may be any one of an air conditioner compressor cooling system, a fan heat sink cooling system, a phase change material cooling system, and the like. This is not limited in this application.

As mentioned above, super charging is performed only when the temperature of the battery 42 in the to-be-charged apparatus 40 falls within an appropriate temperature range. In this case, if the temperature of the battery 42 is low or high during super charging, the battery 42 needs to be preheated or cooled to the appropriate temperature range.

Therefore, optionally, the second cooling system 43 may also include a second heating apparatus (not shown), and the second heating apparatus is configured to heat the third heat conduction pipeline 431 and the fourth heat conduction pipeline 432. In this way, when super charging is performed after the charging apparatus 30 and the to-be-charged apparatus 40 are interconnected, if the temperature of the battery 42 is low, the battery 42 may be heated by using a heating function of the cooling system in the charging apparatus 30. However, it should be understood that disposing the second heating apparatus in the to-be-charged apparatus 40 results in an increase in a size and a weight of the to-be-charged apparatus 40. In addition, when the battery 42 is heated by the second heating apparatus in the to-be-charged apparatus 40, a battery level of the battery 42 is consumed. Furthermore, operating power of the heating apparatus in the to-be-charged apparatus 40 is low. Therefore, in practice, the second heating apparatus may not be disposed in the to-be-charged apparatus 40, or the heating apparatus in the to-be-charged apparatus 40 is not used. This is not limited in this application.

Optionally, the second heating apparatus may be any one of a positive temperature coefficient PTC thermistor heating system, a heat pump system, a motor preheating system, and the like. This is not limited in this application.

Optionally, a cooling pipeline may be further integrated inside the second cable 44, or a cooling pipeline may be wrapped outside the second cable 44, to cool the second cable 44 during charging. A cooling manner of the second cable 44 is not limited in this application.

Optionally, the to-be-charged apparatus 40 may further include a second control system, configured to control operations of the battery 42 and the second cooling system 43, and connect to the first control system for communication.

Based on the foregoing descriptions of the charging apparatus 30 and the to-be-charged apparatus 40, for the charging system 200 during charging, the first electrical transmission interface 311, the first heat conduction output interface 312, and the first heat conduction input interface 313 in the charging plug 31 in the charging apparatus 30 may be respectively connected to the second electrical transmission interface 411, the second heat conduction input interface 412, and the second heat conduction output interface 413 in the charging socket-outlet 31 in the to-be-charged apparatus 40. In this case, the first cooling system 32 in the charging apparatus 30 and the second cooling system 43 in the to-be-charged apparatus 40 form a heat conduction loop. Further, in the charging process, the battery 42 in the to-be-charged apparatus 40 may be cooled or heated by the high-power cooling apparatus or the heating apparatus in the first cooling system 32 in the charging apparatus 30, to improve a cooling or heating speed, shorten cooling or heating time, and improve energy utilization.

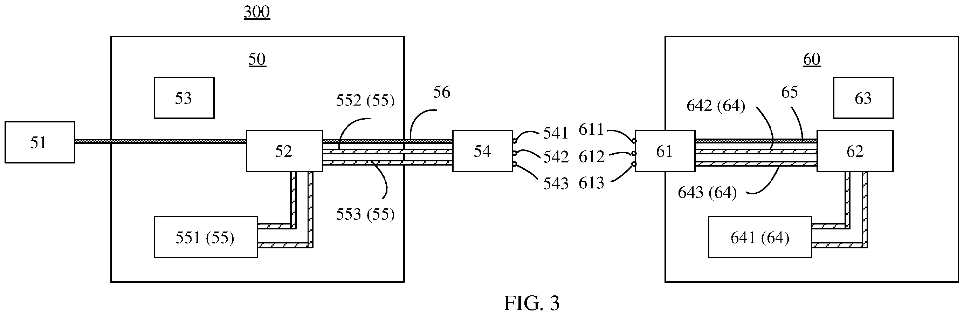

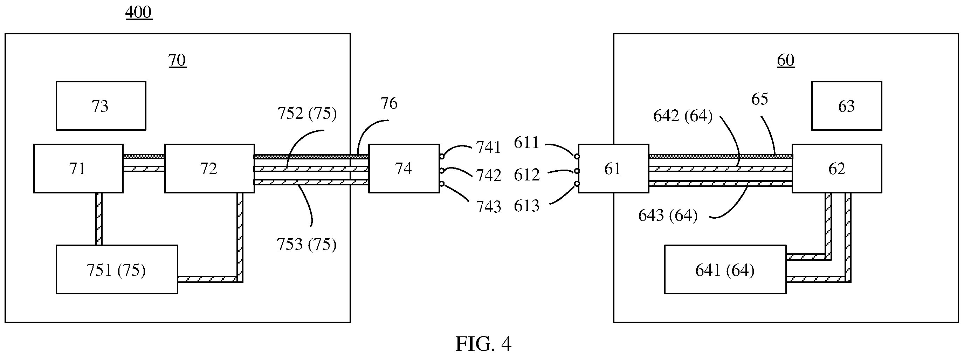

The following describes a charging system in this application by using examples with reference to FIG. 3 and FIG. 4.

FIG. 3 is an example diagram of a charging system including a charging pile and a to-be-charged vehicle according to an embodiment of this application. As shown in FIG. 3, in this example, the charging system 300 mainly includes a charging pile 50 and a to-be-charged vehicle 60.

The charging pile 50 mainly includes a power distribution system 51, a power transformation system 52, a pile control system 53, a charging plug 54, a pile cooling system 55, a cable 56, and the like. The charging plug 54 includes a first communication interface (not shown), a first electrical transmission interface 541, a first heat conduction output interface 542, a first heat conduction input interface 543, and the like. The pile cooling system 55 includes a first cooling apparatus 551, a first heat conduction pipeline 552, and a second heat conduction pipeline 553. The to-be-charged vehicle 60 mainly includes a charging socket-outlet 61, a power battery 62, a vehicle control system 63, a vehicle battery cooling system 64, a cable 65, and the like. The charging socket-outlet 61 includes a second communication interface (not shown), a second electrical transmission interface 611, a second heat conduction input interface 612, a second heat conduction output interface 613, and the like. The vehicle battery cooling system 64 includes a second cooling apparatus 641, a third heat conduction pipeline 642, and a fourth heat conduction pipeline 643. It should be understood that, for a connection manner of the heat conduction pipeline, refer to the foregoing descriptions. It should be understood that the components in this example and the components in the charging system 200 may correspond to each other. Therefore, for related descriptions, refer to the descriptions of the system 200.

It should be understood that, in this example, the cooling systems in the charging pile 50 and the to-be-charged vehicle 60 may be integrally connected through the heat conduction pipelines and the interfaces, to implement exchange between heat conduction media in the charging pile 50 and the to-be-charged vehicle 60.

It should be understood that, when super charging is used, the charging pile, the charging plug, the charging socket-outlet, the pile control system, and the like may also be respectively referred to as a super charging pile, a super charging plug, a super charging socket-outlet, a super charging pile control system, and the like. This is not limited in this application.

The following describes functions of the components in the charging system 300.

The power distribution system 51 may be a power distribution system of the State Grid.

The power transformation system 52 is mainly configured to convert an alternating current into a direct current, to output stable direct current power.

The pile control system 53 is mainly configured to control operations of the power transformation system 52 and the pile cooling system 55, and communicate with the vehicle control system 63 and the power battery 62.

The pile cooling system 55, namely, the first cooling system, includes the first cooling apparatus 551, configured to cool pile heat conduction pipelines. Optionally, a heating apparatus may further be integrated into the pile cooling system 55, so that when the charging pile 50 operates, a cooling or heating function of the entire charging system from the pile to the vehicle is provided. It should be understood that, for types of the cooling apparatus and the heating apparatus, refer to the foregoing descriptions. Details are not described again.

The charging plug 54 may be a GB standard direct current charging plug on which the first heat conduction output interface 542 and the first heat conduction input interface 543 are added. The GB standard direct current charging plug includes a communication GB standard interface and an electrical transmission GB standard interface, which are used for connections of communication and electric energy. The first heat conduction output interface 542 and the first heat conduction input interface 543 each may use a quick plug in/out anti-overflow interconnection connector.

The charging socket-outlet 61 may be a GB standard direct current charging socket-outlet on which the second heat conduction input interface 612 and the second heat conduction output interface 613 are added on the charging socket-outlet 61. The GB standard direct current charging socket-outlet also includes a communication GB standard interface and an electrical transmission GB standard interface, which are configured to connections of communication and electric energy. The second heat conduction input interface 612 and the second heat conduction output interface 613 respectively correspond to the first heat conduction output interface 542 and the first heat conduction input interface 543 in the charging plug 54.

The power battery 62 is an energy storage system of the to-be-charged vehicle 60. A liquid cooling design needs to be integrated inside the power battery 62 (in other words, a cooling channel is integrated), and coolant inlet and outlet interfaces are provided outside the power battery 62. An internal battery management system (battery management system, BMS) communicates with the pile control system 53.

The vehicle battery cooling system 64 is the second cooling system, namely, the cooling system of the power battery 62 in the to-be-charged vehicle 60, and includes the second cooling apparatus 641, configured to provide a cooling function together with the pile cooling system 55 when the vehicle is charged. Optionally, a heating apparatus may be further integrated into the vehicle battery cooling system 64, or no heating apparatus is required. This is not limited.

The vehicle control system 63 is mainly configured to control operations of the power battery 62 and the vehicle battery cooling system 64, and connect to the pile control system 53 for communication.

FIG. 4 is an example diagram of a charging system including a mobile charging vehicle and a to-be-charged vehicle according to an embodiment of this application. As shown in FIG. 4, in this example, the charging system 400 mainly includes a mobile charging vehicle 70 and a to-be-charged vehicle 60.

In the charging system 400, the mobile charging vehicle 70 mainly includes an energy storage battery 71, a power transformation system 72, a mobile charging vehicle control system 73, a charging plug 74, a mobile charging vehicle cooling system 75 (namely, a first cooling system), a cable 76, and the like. The charging plug 74 includes a first communication interface (not shown), a first electrical transmission interface 741, a first heat conduction output interface 742, a first heat conduction input interface 743, and the like. The mobile charging vehicle cooling system 75 includes a first cooling apparatus 751, a first heat conduction pipeline 752, and a second heat conduction pipeline 753. For the to-be-charged vehicle 60, refer to the foregoing descriptions. In addition, for a connection manner of the heat conduction pipeline, also refer to the foregoing descriptions.

It should be understood that, in this example, power is mainly distributed by using the energy storage battery 71. For other components and structures, refer to the descriptions in FIG. 2 and FIG. 3. Details are not described again.

This application further provides a charging plug. For details, refer to the descriptions of the charging plug 31 in FIG. 2, or refer to the descriptions of the charging plug 54 in FIG. 3, or refer to the descriptions of the charging plug 74 in FIG. 4.

This application further provides a charging socket-outlet. For details, refer to the descriptions of the charging socket-outlet 41 in FIG. 2, or refer to the descriptions of the charging socket-outlet 61 in FIG. 3 and FIG. 4.

This application further provides a charging apparatus. For details, refer to the descriptions of the charging apparatus 30 in FIG. 2.

This application further provides a to-be-charged apparatus. For details, refer to the descriptions of the to-be-charged apparatus 40 in FIG. 2.

This application further provides a charging pile. The charging pile includes the charging plug 31 in FIG. 2; or includes the charging apparatus 30 in FIG. 2.

This application further provides a mobile charging vehicle. The mobile charging vehicle includes the charging plug 31 in FIG. 2; or includes the charging apparatus 30 in FIG. 2.

This application further provides an electric vehicle. The electric vehicle includes the charging plug 31 in FIG. 2; or includes the charging apparatus 30 in FIG. 2; or includes the charging socket-outlet 41 in FIG. 2; or includes the to-be-charged apparatus 40 in FIG. 2.

It can be learned that the electric vehicle may serve as a charging apparatus, or may serve as a to-be-charged apparatus. This means that, in practice, a second electric vehicle including the to-be-charged apparatus may be charged by a first electric vehicle including the charging apparatus.

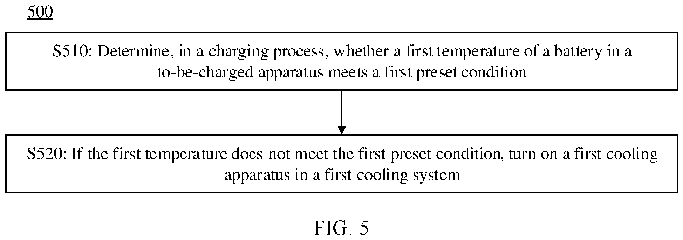

FIG. 5 is an example diagram of a control method according to an embodiment of this application. It should be understood that the method may be applied to a charging system (for example, the charging system 200, 300, or 400) in embodiments of this application, and a first cooling system in a charging apparatus in the charging system and a second cooling system in a to-be-charged apparatus in the charging system form a heat conduction loop. As shown in FIG. 5, the control method 500 includes steps S510 and S520.

S510: Determine, in a charging process, whether a first temperature of a battery in the to-be-charged apparatus meets a first preset condition.

It should be understood that determining whether the first temperature meets the first preset condition may be determining whether the first temperature in the charging process is less than a first preset value. If the first temperature is less than the first preset value, the first temperature meets the first preset condition; or if the first temperature is greater than or equal to the first preset value, the first temperature does not meet the first preset condition.

S520: If the first temperature does not meet the first preset condition, turn on a first cooling apparatus in the first cooling system to cool the battery.

It should be understood that, in the charging process, a temperature of the battery usually rises, and especially in a super charging process, a temperature of the battery rises sharply. In this case, in the charging process, whether the battery needs to be cooled needs to be determined based on the temperature of the battery.

In this embodiment of this application, if the first temperature of the battery does not meet the first preset condition, in other words, when the first temperature is high, the battery may be cooled by using a cooling function of the first cooling system in the charging apparatus. This can improve a heat dissipation effect of the battery, and reduce power consumption of the to-be-charged apparatus.

Correspondingly, if the first temperature meets the first preset condition, the first cooling apparatus in the first cooling system does not need to be turned on.

Optionally, after the first cooling apparatus in the first cooling system is turned on to cool the battery, if the system determines that a battery level of the battery meets the first preset condition, the system may choose to keep the first cooling apparatus in the first cooling system on or turn off the first cooling apparatus in the first cooling system. This is not limited.

Optionally, in an actual charging process, the first cooling apparatus in the first cooling system may be directly turned on without determining the temperature of the battery, to control the temperature of the battery to fall within an appropriate range in the charging process. This is not limited in this application.

Optionally, before charging, whether a second temperature of the battery in the to-be-charged apparatus meets a second preset condition may be further first determined. If the second temperature does not meet the second preset condition, the first cooling apparatus or a first heating apparatus in the first cooling system is turned on to cool or heat the battery.

It should be understood that determining whether the second temperature meets the second preset condition may be determining whether the second temperature before charging falls within a preset temperature range or is a second preset value. If the second temperature falls within the preset temperature range, the second temperature meets the second preset condition; or if the second temperature does not fall within the preset temperature range, the second temperature does not meet the second preset condition; or if the second temperature is the second preset value, the second temperature meets the second preset condition; or if the second temperature is not the second preset value, the second temperature does not meet the second preset condition.

It should be understood that, before charging, especially before super charging, a charging condition can be met only when the temperature of the battery falls within the appropriate temperature range or is the second preset value. Therefore, in this embodiment of this application, before charging is performed, if the second temperature of the battery does not meet the second preset condition, the battery may be cooled or heated by using a cooling function or a heating function of the first cooling system in the charging apparatus, so that the temperature of the battery can meet the charging condition.

Optionally, in an actual charging procedure, operations of charging plug plug-in and communication interaction further need to be first performed before charging. For the operations of charging plug plug-in and communication interaction, refer to the following descriptions.

Optionally, in practice, before charging is performed, a user may further place an order to determine charging-related information. For details, refer to the following descriptions.

Optionally, after charging, whether a third temperature of the battery in the to-be-charged apparatus meets a third preset condition may be further determined. If the third temperature does not meet the third preset condition, the first cooling apparatus is turned on to cool the battery.

It should be understood that determining whether the third temperature meets the third preset condition may be determining whether the third temperature after charging is less than a third preset value. If the third temperature is less than the third preset value, the third temperature meets the third preset condition; or if the third temperature is greater than or equal to the third preset value, the third temperature does not meet the third preset condition.

In this embodiment of this application, after charging is performed, if the third temperature of the battery does not meet the third preset condition, the battery may be cooled by using the cooling function of the first cooling system in the charging apparatus, to facilitate normal use of the battery subsequently.

Optionally, in the actual charging procedure, after charging is completed and the battery is at an appropriate temperature, a charging plug plug-out operation further needs to be performed. For details, refer to the following descriptions.

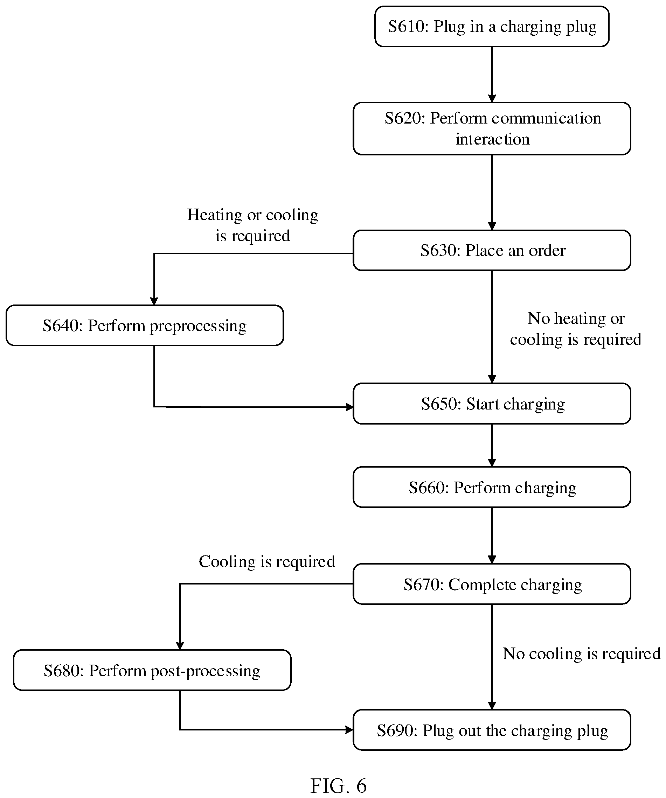

FIG. 6 is an example diagram of an operation procedure during charging according to an embodiment of this application. The operation procedure may be applied to the charging systems 200 to 400. It should be understood that the procedure is merely used as an example, and does not constitute a limitation on this application. Optionally, the charging operation procedure may be an example of a charging operation procedure during super charging. As shown in FIG. 6, when a to-be-charged apparatus is ready to be charged, the operation procedure mainly includes the following steps S610 to S690.

S610: Plug in a charging plug.

The charging plug is correspondingly connected to interfaces in a charging socket-outlet, to implement connections of communication, electric energy, and heat conduction pipelines, and form a heat conduction loop.

Optionally, the charging plug may be directly plugged in by a user, or the charging plug may be automatically plugged in by using an automatic charging plug plug-in apparatus controlled by a control system. This is not limited in this application.

S620: Perform communication interaction.

A control system in the charging apparatus performs communication interaction with a control system and the battery in the to-be-charged apparatus, including a GB standard charging handshake procedure and determining of a charging power capability and a battery temperature status.

S630: Place an order.

The user may select charging-related information on a human-machine interaction interface of the charging apparatus or an order placement page of an application in a mobile terminal, including charging time, power, a charging completion condition, a thermal management requirement (of the charging apparatus or the to-be-charged apparatus or both), and the like.

S640: Perform preprocessing.

If a temperature of the battery is high or low, to meet a charging condition, the temperature of the battery needs to be adjusted to a preset range. Specifically, the battery may be heated or cooled by using a thermal management function (namely, a heating or cooling function) of the charging apparatus. If the to-be-charged apparatus also has a thermal management function, the thermal management function may also be enabled based on order information of the user. If the battery does not need to be heated or cooled, this step may be skipped, and then charging is started.

S650: Start charging.

The entire charging system is cooled by using the cooling system in the charging apparatus, to ensure that the temperature falls within the preset range. If the to-be-charged apparatus also has a battery cooling system, whether to enable the battery cooling system may be determined based on order information or an actual situation.

S660: Perform charging.

Charging power and thermal management system power are adjusted in real time based on the order information of the user and statuses of the charging apparatus and the to-be-charged apparatus, and then charging information is fed back to the user. For example, a charging indicator may be used to indicate that charging is being performed. For example, if the charging indicator is steady on or blinks, it indicates that charging is being performed.

S670: Complete charging.

If the to-be-charged apparatus is fully charged, the order charging completion condition is met, or a fault occurs, charging is stopped, and the user is notified. For example, the charging indicator may be used to indicate that the charging is completed. For example, if the charging indicator is off, it indicates that charging is completed. For example, a fault indicator may be used to indicate that a fault occurs. For example, if the fault indicator is steady on or blinks, it indicates that a fault occurs.

S680: Perform post-processing.

Optionally, after the charging is completed, a status of the to-be-charged apparatus may be fed back to the user, and the user may choose, based on the temperature of the battery, whether to control the temperature of the battery and a temperature difference. Alternatively, the charging system may directly adjust the temperature of the battery and a temperature difference to the preset range based on an initial order information. Optionally, if a heat exchange indicator is steady on, blinks, or the like, it indicates that cooling processing is being performed.

In this step, the battery may be cooled by using a cooling function of the charging apparatus. If the to-be-charged apparatus also has a cooling function, the cooling function may be enabled or may be disabled. If it is determined that the temperature of the battery does not fall within the preset range, but the cooling function of the to-be-charged apparatus is sufficiently used to cool the battery, only the cooling function of the to-be-charged apparatus may be enabled. This is not limited.

If the battery does not need to be cooled, this step may be skipped, and then the charging plug starts to be plugged out.

S690: Plug out the charging plug.

When the charging and heat exchange indicators all display termination, the user is notified that the charging is completed, and the charging plug waits for being plugged out by the user, or a service person plugs out the charging plug, or the charging plug automatically plugs out. In this case, the charging plug is disconnected from the charging socket-outlet, connections of communication, electric energy transmission, and heat conduction media between the charging apparatus and the to-be-charged apparatus are all disconnected, and the charging indicator and the heat exchange indicator each display a standby state.

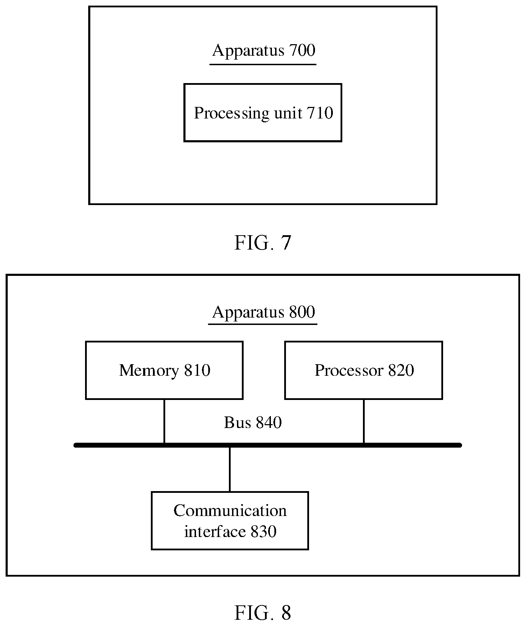

FIG. 7 shows an example of a control apparatus according to an embodiment of this application. It should be understood that, as shown in FIG. 7, the apparatus includes a processing unit 710. It should be understood that the apparatus 710 may be used in a charging system (for example, the charging system 200, 300, or 400) in embodiments of this application, and a first cooling system in a charging apparatus in the charging system and a second cooling system in a to-be-charged apparatus in the charging system form a heat conduction loop.

It should be understood that, in a charging process, the processing unit 710 is configured to: determine whether a first temperature of a battery in the to-be-charged apparatus meets a first preset condition; and if the first temperature does not meet the first preset condition, turn on a first cooling apparatus in the first cooling system to cool the battery.

Optionally, before charging, the processing unit 710 may be further configured to: determine whether a second temperature of the battery in the to-be-charged apparatus meets a second preset condition; and if the second temperature does not meet the second preset condition, turn on the first cooling apparatus or a first heating apparatus in the first cooling system to cool or heat the battery.

Optionally, after charging, the processing unit 710 may be further configured to: determine whether a third temperature of the battery in the to-be-charged apparatus meets a third preset condition; and if the third temperature does not meet the third preset condition, turn on the first cooling apparatus to cool the battery.

FIG. 8 is a block diagram of an example of a hardware structure of an apparatus according to an embodiment of this application. Optionally, the apparatus 800 may be specifically a computer device. The apparatus 800 includes a memory 810, a processor 820, a communication interface 830, and a bus 840. The memory 810, the processor 820, and the communication interface 830 implement mutual communication connections through the bus 840.

The memory 810 may be a read-only memory (read-only memory, ROM), a static storage device, a dynamic storage device, or a random access memory (random access memory, RAM). The memory 810 may store a program. When the program stored in the memory 810 is executed by the processor 820, the processor 820 is configured to perform steps of the control method in embodiments of this application.

The processor 820 may be a general-purpose CPU, a microprocessor, an ASIC, a graphics processing unit (graphics processing unit, GPU), or one or more integrated circuits, and is configured to execute a related program, to implement the control method in the method embodiments of this application.

Alternatively, the processor 1120 may be an integrated circuit chip and has a signal processing capability. In an implementation process, the control method in this application may be completed by using a hardware integrated logic circuit in the processor 820 or instructions in a form of software.

Alternatively, the processor 820 may be a general-purpose processor, a digital signal processor (digital signal processor, DSP), an ASIC, an FPGA or another programmable logic device, a discrete gate or a transistor logic device, or a discrete hardware component. The processor may implement or perform the methods, the steps, and logical block diagrams that are disclosed in embodiments of this application. The general-purpose processor may be a microprocessor, or the processor may be any conventional processor or the like. The steps in the method disclosed with reference to embodiments of this application may be directly performed and completed by a hardware decoding processor, or may be performed and completed by a combination of hardware and software modules in a decoding processor. A software module may be located in a mature storage medium in the art, like a random access memory, a flash memory, a read-only memory, a programmable read-only memory, an electrically erasable programmable memory, or a register. The storage medium is located in the memory 810. The processor 820 reads information in the memory 810, and completes, in combination with hardware of the processor 820, a function that needs to be executed by a module included in the apparatus in embodiments of this application, or performs the control method in the method embodiments of this application.

The communication interface 830 uses a transceiver apparatus, for example but not limited to, a transceiver, to implement communication between the apparatus 800 and another device or a communication network.

The bus 840 may include a path for transmitting information between the components (for example, the memory 810, the processor 820, and the communication interface 830) of the apparatus 800.

An embodiment of this application further provides a computing device, including at least one processor and a memory. The at least one processor is coupled to the memory, and is configured to read and execute instructions in the memory, to perform the control method in the method embodiments of this application.

An embodiment of this application further provides a computer program product including instructions. When the computer program product runs on a computer, the computer is enabled to perform the control method in the method embodiments of this application.

An embodiment of this application further provides a computer-readable storage medium, including instructions. The instructions are used to implement the control method in the method embodiments of this application.

An embodiment of this application further provides a chip. The chip includes a processor and a data interface. The processor reads, through the data interface, instructions stored in a memory to perform the control method in the method embodiments of this application.

Optionally, in an implementation, the chip may further include the memory. The memory stores the instructions, and the processor is configured to execute the instructions stored in the memory. When the instructions are executed, the processor is configured to perform the control method in the method embodiments of this application.

A person of ordinary skill in the art may be aware that units and algorithm steps in the examples described with reference to embodiments disclosed in this specification can be implemented by electronic hardware or a combination of computer software and electronic hardware. Whether the functions are executed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In the several embodiments provided in this application, it should be understood that the disclosed system, apparatus and method may be implemented in other manners. For example, the described apparatus embodiment is merely an example. For example, division into the units is merely logical function division and may be other division during actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on an actual requirement to achieve the objectives of the solutions of embodiments.

In addition, functional units in embodiments of this application may be integrated into one processing unit, each of the units may exist alone physically, or two or more units may be integrated into one unit.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A charging plug, comprising: a first electrical transmission interface, a first heat conduction output interface, and a first heat conduction input interface, wherein
the first electrical transmission interface is configured to transmit electric energy to a to-be-charged apparatus, the first heat conduction output interface is configured to output a heat conduction medium to the to-be-charged apparatus, and the first heat conduction input interface is configured to receive the heat conduction medium input from the to-be-charged apparatus.

2. The charging plug according to claim 1, wherein the first heat conduction output interface and/or the first heat conduction input interface use/uses a quick plug in/out anti-overflow interconnection connector.

3. The charging plug according to claim 1 or 2, wherein the charging plug further comprises a first communication interface, and the first communication interface is configured to communicate with the to-be-charged apparatus.

4. A charging socket-outlet, comprising: a second electrical transmission interface, a second heat conduction output interface, and a second heat conduction input interface, wherein
the second electrical transmission interface is configured to transmit electric energy to a charging apparatus, the second heat conduction output interface is configured to output a heat conduction medium to the charging apparatus, and the second heat conduction input interface is configured to receive the heat conduction medium input from the charging apparatus.

5. The charging socket-outlet according to claim 4, wherein the second heat conduction output interface and/or the second heat conduction input interface use/uses a quick plug in/out anti-overflow interconnection connector.

6. The charging socket-outlet according to claim 4 or 5, wherein the charging socket-outlet further comprises a second communication interface, and the second communication interface is configured to communicate with the charging apparatus.

7. A charging apparatus, comprising: the charging plug according to any one of claims 1 to 3 and a first cooling system, wherein the first cooling system comprises a first cooling apparatus, a first heat conduction pipeline, and a second heat conduction pipeline, the first cooling apparatus is configured to cool the first heat conduction pipeline and the second heat conduction pipeline, one end of the first heat conduction pipeline communicates with one end of the second heat conduction pipeline, and the other end of the first heat conduction pipeline and the other end of the second heat conduction pipeline are respectively connected to a first heat conduction output interface and a first heat conduction input interface in the charging plug.

8. The charging apparatus according to claim 7, wherein the first cooling apparatus comprises any one of an air conditioner compressor cooling system, a fan heat sink cooling system, and a phase change material cooling system.

9. The charging apparatus according to claim 7 or 8, wherein the first cooling system further comprises a first heating apparatus, and the first heating apparatus is configured to heat the first heat conduction pipeline and the second heat conduction pipeline.

10. The charging apparatus according to claim 9, wherein the first heating apparatus comprises any one of a positive temperature coefficient PTC thermistor heating system, a heat pump system, and a motor preheating system.

11. A to-be-charged apparatus, comprising: a battery, the charging socket-outlet according to any one of claims 4 to 6, and a second cooling system, wherein the second cooling system comprises a third heat conduction pipeline and a fourth heat conduction pipeline, one end of the third heat conduction pipeline and one end of the fourth heat conduction pipeline are connected to the battery and communicate with each other, and the other end of the third heat conduction pipeline and the other end of the fourth heat conduction pipeline are respectively connected to a second heat conduction input interface and a second heat conduction output interface in the charging socket-outlet.

12. The to-be-charged apparatus according to claim 11, wherein the second cooling system further comprises a second cooling apparatus, and the second cooling apparatus is configured to cool the third heat conduction pipeline and the fourth heat conduction pipeline.

13. The to-be-charged apparatus according to claim 12, wherein the second cooling apparatus comprises any one of an air conditioner compressor cooling system, a fan heat sink cooling system, and a phase change material cooling system.

14. The to-be-charged apparatus according to any one of claims 11 to 13, wherein the second cooling system further comprises a second heating apparatus, and the second heating apparatus is configured to heat the third heat conduction pipeline and the fourth heat conduction pipeline.

15. The to-be-charged apparatus according to claim 14, wherein the second heating apparatus comprises any one of a positive temperature coefficient PTC thermistor heating system, a heat pump system, and a motor preheating system.

16. A charging system, comprising: the charging apparatus according to any one of claims 7 to 10 and the to-be-charged apparatus according to any one of claims 11 to 15, wherein when a first electrical transmission interface, a first heat conduction output interface, and a first heat conduction input interface in a charging plug in the charging apparatus are respectively connected to a second electrical transmission interface, a second heat conduction input interface, and a second heat conduction output interface in a charging socket-outlet in the to-be-charged apparatus, a first cooling system in the charging apparatus and a second cooling system in the to-be-charged apparatus form a heat conduction loop.

17. A charging pile, comprising the charging plug according to any one of claims 1 to 3, or comprising the charging apparatus according to any one of claims 7 to 10.

18. A mobile charging vehicle, comprising the charging plug according to any one of claims 1 to 3, or comprising the charging apparatus according to any one of claims 7 to 10.

19. An electric vehicle, comprising the charging plug according to any one of claims 1 to 3, or comprising the charging apparatus according to any one of claims 7 to 10, or comprising the charging socket-outlet according to any one of claims 4 to 6, or comprising the to-be-charged apparatus according to any one of claims 11 to 15.

20. A control method, wherein the method is applied to the charging system according to claim 16, a first cooling system in a charging apparatus in the charging system and a second cooling system in a to-be-charged apparatus in the charging system form a heat conduction loop, and the method comprises:
determining, in a charging process, whether a first temperature of a battery in the to-be-charged apparatus meets a first preset condition; and
if the first temperature does not meet the first preset condition, turning on a first cooling apparatus in the first cooling system to cool the battery.

21. The method according to claim 20, wherein the first preset condition comprises: the first temperature is less than a first preset value.

22. The method according to claim 20 or 21, wherein the method further comprises:
determining, before charging, whether a second temperature of the battery in the to-be-charged apparatus meets a second preset condition; and
if the second temperature does not meet the second preset condition, turning on the first cooling apparatus or a first heating apparatus in the first cooling system to cool or heat the battery, wherein the second preset condition comprises: the second temperature falls within a preset temperature range, or the second temperature is a second preset value.

23. The method according to any one of claims 20 to 22, wherein the method further comprises:
determining, after charging, whether a third temperature of the battery in the to-be-charged apparatus meets a third preset condition; and
if the third temperature does not meet the third preset condition, turning on the first cooling apparatus to cool the battery, wherein the third preset condition comprises: the third temperature is less than a third preset value.

24. A control apparatus, wherein the apparatus is used in the charging system according to claim 16, a first cooling system in a charging apparatus in the charging system and a second cooling system in a to-be-charged apparatus in the charging system form a heat conduction loop, the apparatus comprises a processing unit, and in a charging process, the processing unit is configured to:
determine whether a first temperature of a battery in the to-be-charged apparatus meets a first preset condition; and if the first temperature does not meet the first preset condition, turn on a first cooling apparatus in the first cooling system to cool the battery.

25. The apparatus according to claim 24, wherein the first preset condition comprises: the first temperature is less than a first preset value.

26. The apparatus according to claim 24 or 25, wherein before charging, the processing unit is further configured to:
determine whether a second temperature of the battery in the to-be-charged apparatus meets a second preset condition; and if the second temperature does not meet the second preset condition, turn on the first cooling apparatus or a first heating apparatus in the first cooling system to cool or heat the battery, wherein the second preset condition comprises: the second temperature falls within a preset temperature range, or the second temperature is a second preset value.

27. The apparatus according to any one of claims 24 to 26, wherein after charging, the processing unit is further configured to:
determine whether a third temperature of the battery in the to-be-charged apparatus meets a third preset condition; and if the third temperature does not meet the third preset condition, turn on the first cooling apparatus to cool the battery, wherein the third preset condition comprises: the third temperature is less than a third preset value.

28. A control apparatus, comprising a processor and a memory, wherein the processor runs instructions in the memory, so that the control apparatus performs the control method according to any one of claims 20 to 23.

29. A computer-readable storage medium, comprising instructions, wherein the instructions are used to implement the control method according to any one of claims 20 to 23.
